# EUROPEAN PATENT APPLICATION

(11) **EP 4 704 510 A1**
(43) Date of publication of application: **04.03.2026**
(21) Application number: 25198839.0
(22) Date of filing: 28.08.2025
(51) Int. Cl.: H05K 7/20, F25D 17/02, F25B 47/00

(54) **AUXILIARY COOLING RAMP FOR LIVE DATA CENTER MAINTENANCE**

(30) Priority: 28.08.2024 US 202463687981 P
(71) Applicant: Vertiv Corporation, Westerville, OH 43082 (US)
(72) Inventor: Paji , Marin, Westerville, 43082 (US); Gad i , Andrea, Westerville, 43082 (US); Pavlica, Nikola, Westerville, 43082 (US)
(74) Representative: Cousens, Nico

(57) **Abstract**

An auxiliary cooling ramp system and method are provided. The system includes an auxiliary ramp (500) operatively connectable, using a plurality of flexible hoses (131, 132, 133, 134), to water lines of a water circuit of a cooling system (80), between a cooling unit and a heat exchange system (90) of the cooling system. The method includes installing the auxiliary ramp to water lines of a water circuit of a cooling system, between a cooling unit and a heat exchange system of the cooling system; performing maintenance on the cooling system via the auxiliary ramp; and disconnecting the auxiliary ramp.

## Description

This present Application claims the benefit of U.S. Provisional Application 63/687,981, filed August 28, 2024 in the U.S. Patent and Trademark Office.

### BACKGROUND

### 1. Field

Apparatuses and methods consistent with example embodiments relate to maintenance of a combination cooling system, and more specifically to a system and method for maintaining a cooling system without significantly disrupting operation of the combination cooling system.

### 2. Description of Related Art

Combination systems may include a cooling system and a heat exchange system which cycle water therebetween. Such combination cooling systems with chilled water are commonly used for cooling data centers, but are also used in many other industries. The data centers require uninterrupted operation of the IT loads and thus uninterrupted operation of the systems used therefor. However, chilled water that is cycled through a system often becomes contaminated over time, and maintenance, draining, and flushing of the chilled water in the system may be required in order to avoid more serious problems that may be caused by corrosion and scaling from contaminated water.

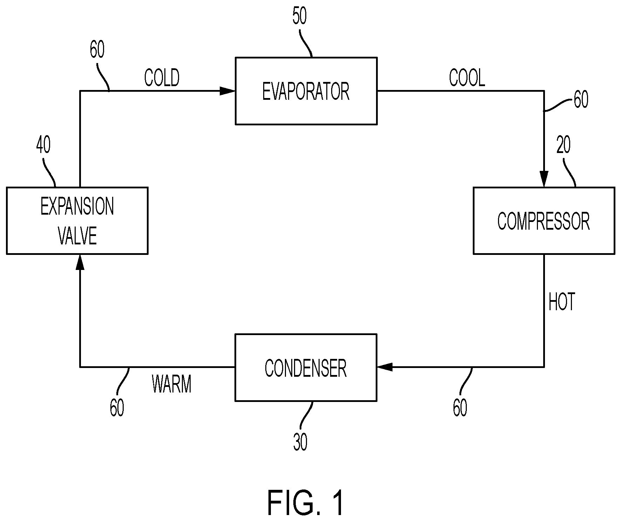

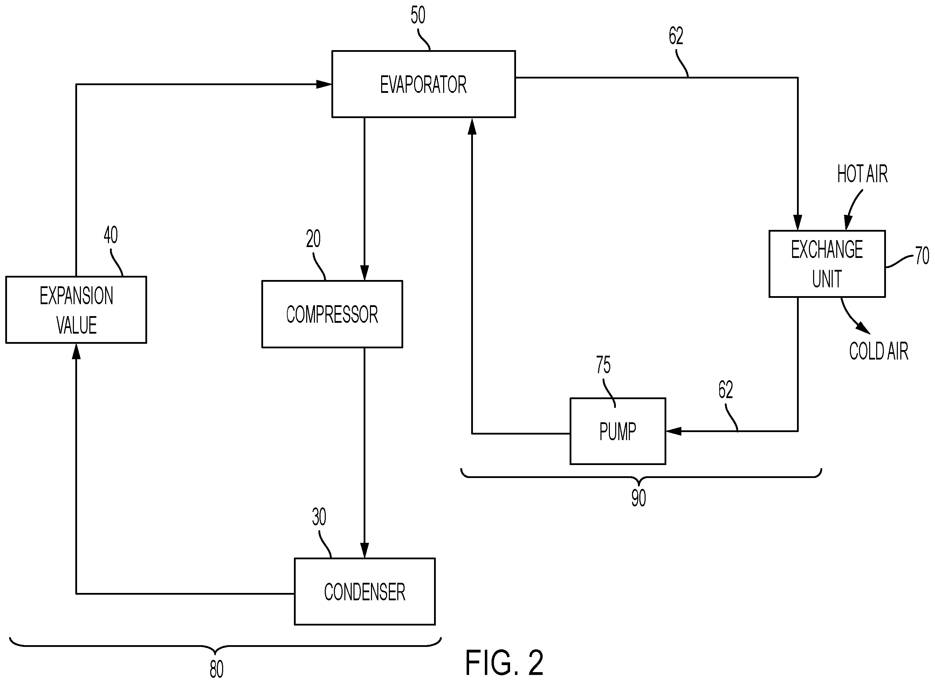

FIG. 1 illustrates an example refrigeration circuit 10 including a condenser 30, an evaporator 50, a compressor 20, and an expansion valve 40 connected by lines 60 which circulate refrigerant through the circuit 10. FIG. 2 illustrates an example combination system including a cooling system 80 which circulates a refrigerant and is operatively connected to a heat exchange system 90. The cooling system 80 and heat exchange system 90 share an evaporator 50. Water cycling through the heat exchange system is cooled in the evaporator 50 shared with the cooling system 80. A pump 75 circulates the cold water from the evaporator 50 to an exchange unit 70 to cool air and circulates the water in lines 62. Water coils may be used within the heat exchange system 90 to cool the air.

Such a combination system as illustrated in FIG. 2, for example, may be used to provide cooling for a modular data center. Such a system may have a constant primary flow hydronic configuration, with balancing achieved using pressure-independent balancing valves, as the pump is a constant speed pump without variable speed drive. Alternately, a combination system may be configured with a constant primary/variable secondary flow configuration or with a variable primary flow configuration.

An issue of poor cooling medium quality in closed circulating chilled water systems may arise both from the absence of chilled water treatment equipment and from inadequate maintenance of the chilled water system. Circulating a cooling medium with poor quality can cause corrosion and scaling within the metal pipes circulating the water in a system. This may lead to leakage and equipment damage including the formation of blockages in heat exchangers due, for example, to compromised coolant quality with elevated iron (Fe) and copper (Cu) levels.

### SUMMARY OF EXAMPLE EMBODIMENTS

Example embodiments may address at least the above problems and/or disadvantages and other disadvantages not described above. Also, example embodiments are not required to overcome the disadvantages described above, and may not overcome any of the problems described above.

According to an aspect of an example embodiment, an auxiliary ramp system may comprise: an auxiliary ramp unit comprising: a supply manifold, a return manifold, a pressure-independent balancing valve operatively connected between the supply manifold and the return manifold, a safety valve operatively connected to the return manifold, and a drain/filling valve operatively connected to one of the supply manifold and the return manifold; and a plurality of flexible hoses comprising: a supply input hose configured to attach to an input of the supply manifold, a supply output hose configured to attach to an output of the supply manifold, a return input hose configured to attach to an input of the return manifold, and a return output hose configured to attach to an output of the return manifold.

The return manifold may comprise a plurality of inputs and a plurality of outputs, and the plurality of flexible hoses may comprise a plurality of return input hoses each configured to attach to one of the plurality of inputs of the return manifold and a plurality of return output hoses each configured to attach to one of the plurality of outputs of the return manifold.

The auxiliary ramp unit may further comprise a deaeration valve operatively connected between the supply manifold and the return manifold.

The auxiliary ramp unit may further comprise an isolation valve operatively connected between the safety valve and the return manifold.

The drain/filling valve may comprise: a first drain filling valve operatively connected to the supply manifold and a second drain/filling valve operatively connected to the return manifold.

The system may further comprise a pump configured to pump water through the supply manifold.

The auxiliary ramp unit may further comprise a first pressure gauge and a first temperature gauge operatively attached to the supply manifold and a second pressure gauge and a second temperature gauge operatively attached to the return manifold.

The auxiliary ramp unit may further comprise an expansion tank operatively connected to the return manifold.

According to an aspect of another example embodiment, a cooling system maintenance method may comprise: draining water from a water circuit of a combined cooling system comprising a cooling unit and a heat exchange system; filling the water circuit with first water via an auxiliary ramp unit, allowing the first water to circulate in the water circuit, and draining the first water from the water circuit, wherein the auxiliary ramp unit is operatively connected on lines of the water circuit between the cooling unit and the heat exchange system; filling the water circuit with a first mixture comprising water and a dispersant via the auxiliary ramp unit, allowing the first mixture to circulate in the water circuit, and draining the first mixture from the water circuit; filling the water circuit with second water via the auxiliary ramp unit, allowing the second water to circulate in the water circuit, and draining the second water from the water circuit; filling the water circuit with a second mixture comprising water and a passivizer/degreaser, allowing the second mixture to circulate in the water circuit, and draining the second mixture; filling the water circuit with third water via the auxiliary ramp unit, allowing the third water to circulate in the water circuit, and draining the second water from the water circuit; and filling the water circuit with a softened water mixture via the auxiliary ramp unit.

The method may further comprise: installing the auxiliary ramp unit between the cooling unit and the heat exchange system, the installing comprising: attaching a flexible supply input hose between an input of the supply manifold and an output of the cooling unit; attaching a flexible supply output hose between an output of the supply manifold and an input of the heat exchange system; attaching a flexible return input hose between an input of the return manifold and an output of the heat exchange system, and attaching a flexible a return output hose between an output of the return manifold and an input of the cooling unit.

The method may further comprise: deaerating the water circuit via a valve operatively connected between the supply manifold and the return manifold.

The allowing the first water to circulate, allowing the second water to circulate, and allowing the first water to circulate may each comprise allowing circulation of the water to continue for an hour prior to draining.

The first mixture may comprise water and the dispersant in a concentration of about 100 ppm.

The second mixture may comprise water and the passivizer/degreaser in a concentration of about 5000 ppm.

The softened water mixture may comprise softened water in a 30% propylene glycol mixture and a corrosion inhibitor.

The softened water mixture may include the corrosion inhibitor in a concentration of about 2800 ppm.

The softened water may have a hardness between about 4.5-8.5 °dH.

The allowing the first mixture to circulate may comprise allowing the first mixture to circulate for about three hours prior to draining the first mixture.

The allowing the second mixture to circulate may comprise allowing the second mixture to circulate for between about 24-48 hours prior to draining the second mixture.

The operations of filling the water circuit may comprise filling the water circuit via a controlled injection using an automatic pressurization system.

### BRIEF DESCRIPTION OF THE DRAWINGS

The above and/or other aspects will become apparent and more readily appreciated from the following description of example embodiments, taken in conjunction with the accompanying drawings, in which:
FIG. 1 illustrates an example related art refrigeration circuit;
FIG. 2 illustrates an example related art system including a cooling system and a heat exchanger;
FIG. 3 is a schematic of an example related art system including a cooling system disposed outside and a heat exchange system disposed inside;
FIG. 4 is a schematic of another example related art system including a chiller and a cooling wall;
FIG. 5 is a schematic of an auxiliary cooling ramp system attached between a cooling system and a heat exchange system according to an example embodiment;
FIG. 6 is a detailed schematic of the auxiliary cooling ramp system of FIG. 5, according to an example embodiment;
FIG. 7 is a schematic of an auxiliary cooling ramp system installed between a heat exchange system and two cooling system units, according to an example embodiment;
FIG. 8 is a perspective view of an auxiliary cooling ramp according to an example embodiment; and
FIG. 9 is a flow chart of a method of operating an auxiliary cooling ramp according to an example embodiment.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

As discussed above, water circulated in cooling systems may become contaminated causing corrosion and scaling and risking damage to the cooling system. Improving the water quality may prevent corrosion and/or scaling from occurring as well as preventing potential blockage of and damage to the heat exchange system as well as other equipment and accessories within the cooling system. Some water quality parameters that may be controlled to improve the water quality are the quantities of calcium (Ca)), copper (Cu), and Iron (Fe), and the potential of hydrogen (pH) level, among others. The turbidity and color of the chilled water in the system may also be controlled in order to improve the water quality.

In order to control or correct these parameters, water within the system should be drained, and the system flushed, both without interrupting the operation of the system and thus without interrupting IT load operation within a data center.

According to one or more example embodiments described herein, an auxiliary cooling ramp system is provided which includes the equipment needed to attach to an existing system, while maintaining both a constant pressure and temporary cooling function in the existing system. The auxiliary cooling ramp system may also include the equipment needed to drain water from the system and flush the system.

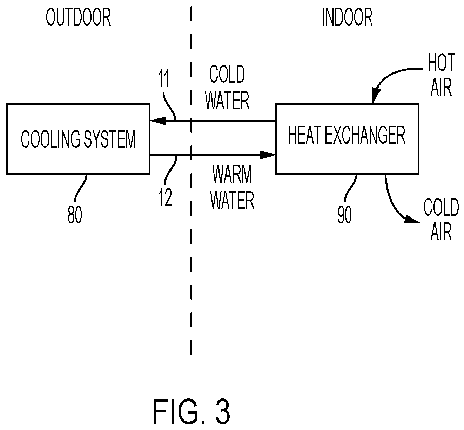

FIG. 3 is a schematic of an example related art system including a cooling system 80, disposed outside, for example on a roof of a data center; a heat exchange system 90 disposed inside a data center; and lines 11, 12 running water through a piping network between the cooling system 80 and the heat exchange system 90.

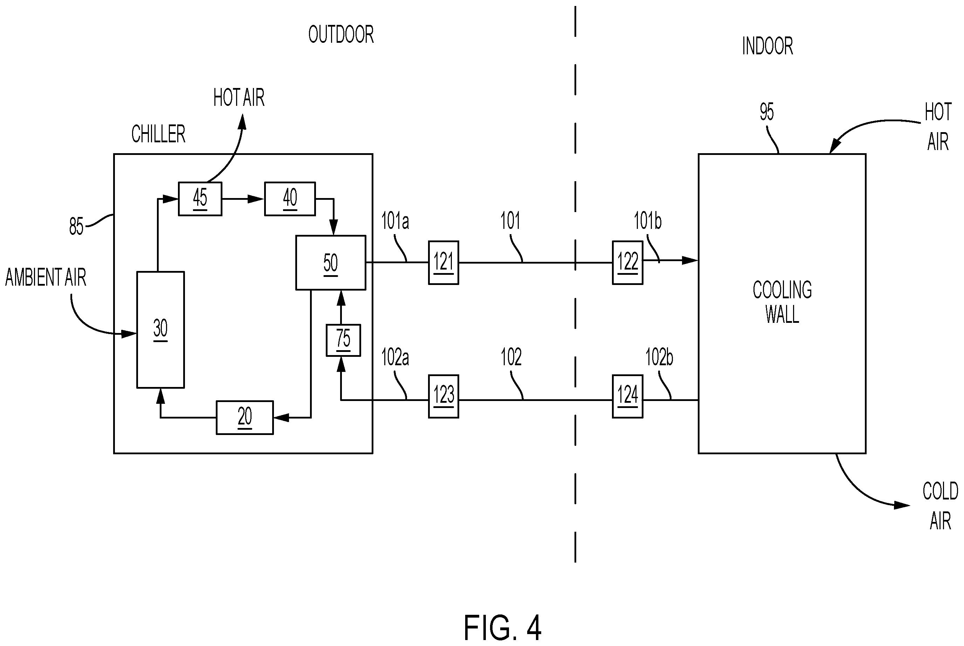

FIG. 4 is a schematic of another example related art system in which a chiller 85 functions as a cooling system disposed, for example on a roof, and a cooling wall 95 functions as a heat exchange system disposed inside a data center. The chiller 85 may be an air-cooled chiller including a refrigeration circuit including an evaporator 50, a compressor 20, a condenser 30, a fan 45, an expansion valve 40, and lines circulating refrigerant through the chiller. A first line 101 conveys water from the chiller 85 to the cooling wall 95, and a second line 102 conveys water from the cooling wall 95 to the chiller 85. Within the chiller 85, a pump 75 pumps water from line 102 into the evaporator 50, which may be, for example, a plate heat exchanger. Cold water is output from the evaporator 50 and conveyed by the pump 75 through line 101 to the cooling wall. Isolation valves 121, 122, 123, and 124 are provided on the lines 101 and 102 between the chiller 85 and the cooling wall 95. The cooling wall 95 may include, for example, two sections, each section including four chilled water coils. It may have, for example, a variable primary flow hydronic configuration with balancing on cooling coils provided by pressure-independent balancing valves, or by a combination of a constant primary speed pump without variable speed drive and cooling coils with pressure-independent balancing valves to provide balancing. Thus, balancing may be achieved regardless of the use of a constant or variable speed pump or the system configuration.

Alternately, the chiller functioning as the cooling system may be a dry cooler which does not include a refrigerant circuit and in which heat is directly exchanged between water and the surrounding ambient air.

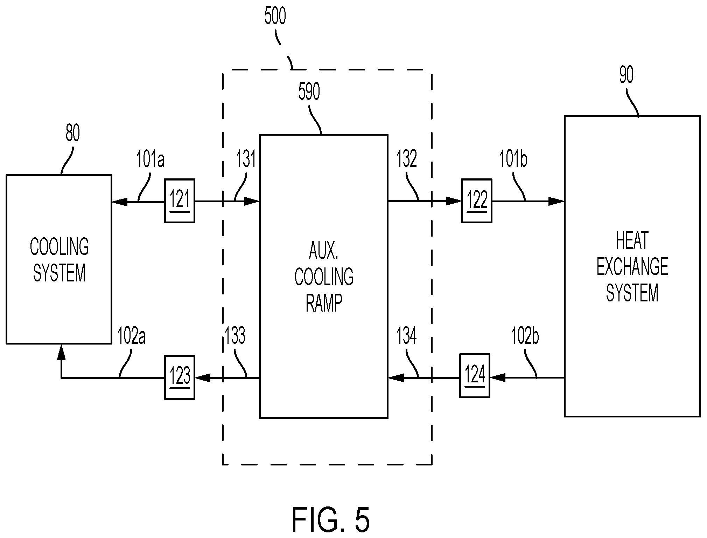

FIG. 5 is a schematic of an auxiliary cooling ramp system 500 attached between a cooling system 80 and a heat exchange system 90, according to an example embodiment. The system 500 is attached between the cooling system and the heat exchange system between valves 121 and 122 on line 101, and between valves 123 and 124 on line 102. The cooling system 80 may be a chiller, and the heat exchange system 90 may be a cooling wall including one or more heat exchangers and one or more air distribution fans.

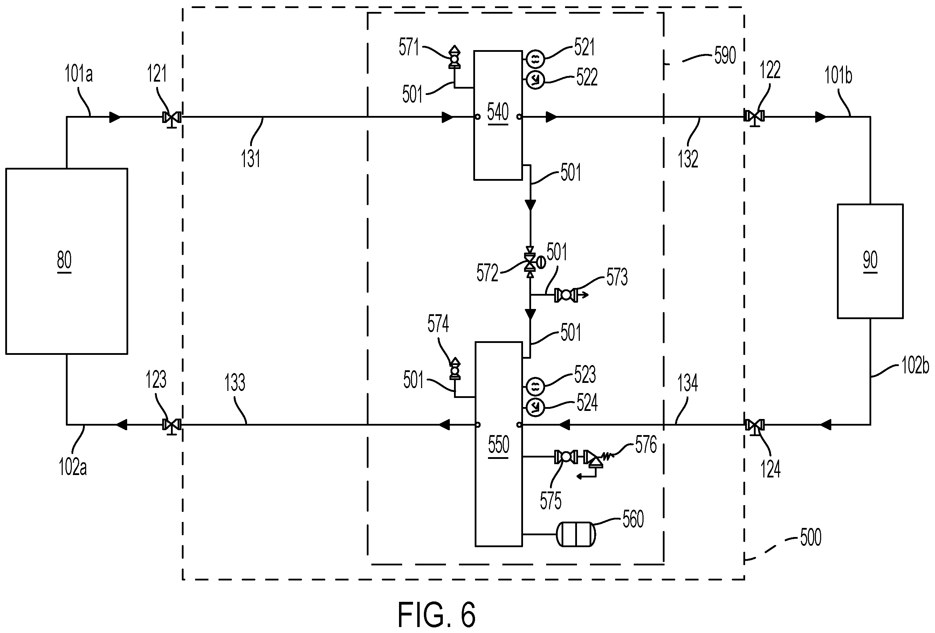

FIG. 6 is a detailed schematic of the auxiliary cooling ramp system 500 according to an example embodiment. The system 500 includes an auxiliary cooling ramp 590. The auxiliary cooling ramp 590 includes a chilled water (CHW) supply manifold 540, a CHW return manifold 550, an expansion tank 560, valves 571-576, and lines 501 connecting the various elements. The expansion tank 560 includes an isolation valve with a lock shield. The valves include: a drain/filling valve 571 attached to the CHW supply manifold 540; a pressure-independent balancing valve 572 disposed on the line between the CHW supply manifold 540 and the CHW return manifold 550, at, for example, a highest ramp point which is a geodesic point at which air tends to escape; a deaeration valve 573 attached on the line between the pressure-independent balancing valve 572 and the CHW return manifold 550; a drain/filling valve 574 attached to the CHW return manifold 550; an isolation valve 575 with a lock shield attached to the CHW return manifold 550, and a safety valve 576 attached to the isolation valve 575. A pressure gauge 521, 523 and temperature gauge 522, 524 may be operatively connected to each of the CHW supply manifold 540 and the CHW return manifold 550. The drain/filling valves 571, 574 may be used to introduce water and one or more additives into the system at the CHW return manifold 550 and the CHW supply manifold 540, respectively. The pressure-independent balancing valve 572, disposed on the bypass line between the CHW return manifold 550 and CHW supply manifold 540 enables system operational stability, management of minimum and/or constant flow requirements, and protection of equipment. The expansion tank 560, in combination with the safety valve 576, enables an operator to operate the system safely under varying conditions, thus also enabling the operator to manage the pressure in the system during operation of the ramp 590 without exceeding a maximum operating pressure. The pressure and temperature gauges 521, 522, 523, 524 are operatively connected to the CHW return manifold 550 and CHW supply manifold 540 and enable an operator to monitor conditions during operation of the ramp 590.

Connectors used within the system 500 may be connectors up to and including diameter nominal (DN) 50 or DN 65, and may be threaded. Connectors above DN 50 or DN 65 may be flanged. However, other types of joints and connectors may be used, so long as they are suitable for the application and operating medium, as would be understood by one of skill in the art. Equipment pressure rating should be compliant with the system requirements. For example, equipment installed in cooling systems may be rated at least pressure nominal (PN) 10 or PN16. The size or DN of equipment should correspond to the applied flows and velocities of the cooling medium. The materials of the installed equipment should be in accordance with the application, the cooling medium, and all substances with which the equipment will come into contact, as would be understood by one of skill in the art. For example, auxiliary ramp pipes, fittings, and flanges made of carbon steel; butterfly valves with cast iron bodies and stainless steel discs; ball valves made of brass; pressure gauge and thermometer connections made of brass or stainless steel, with stainless steel casings with glycerine or silicon oil filling; gaskets and O-rings made of Ethylene propylene diene monomer (EPDM), Polytetrafluoroethylene (PTFE), or nitrile butadiene rubber (NBR); and threaded fittings made of carbon steel, brass, or stainless steel may be used, as would be understood by one of skill in the art.

The system 500 also includes flexible hoses 131, 132, 133, and 134 which operatively connect the auxiliary cooling ramp 590 between the cooling system 80 and heat exchange system 90, and which are respectively connectable to the isolation valves 121, 122, 123, and 124. The hoses 131, 132, 133, 134 are flexible and may be of any length determined to be convenient for connecting to the valves 121, 122, 123, and 124 to the auxiliary cooling ramp 590 in a manner than is both quick and water-tight, while the ramp 590 is disposed in a location providing sufficient and convenient operating space. For example, the hoses 131, 132, 133, 134 may be made of EPDM rubber due to its resistance to glycols and many other different chemicals while also being abrasion and weather resistant, or any of a variety of other materials, as would be understood by one of skill in the art. The flexible hoses enable the auxiliary cooling ramp 590 to be located in any convenient location while operatively connected between the cooling system 80 and the heat exchange system 90.

Installation of the system 500 may be achieved easily by connecting each of the hoses 131, 132, 133, 134 to one of the isolation valves 121, 122, 123, and 124, at a first end, and to the ramp 590, at an opposite end.

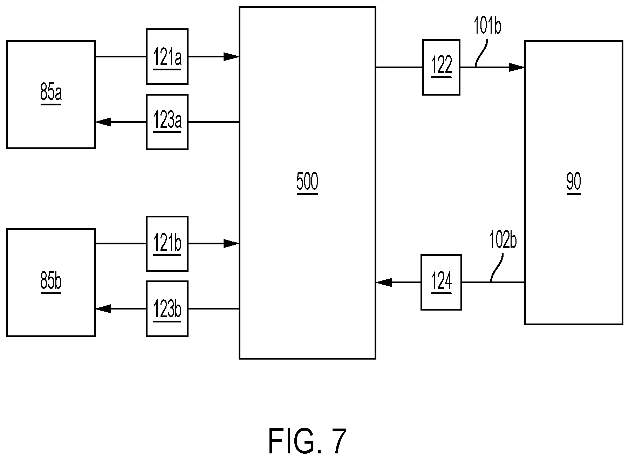

FIG. 7 is a schematic of the auxiliary cooling ramp system 500 installed between a heat exchange system 90 and two cooling system units shown as chillers 85a and 85b, according to an example embodiment. It should be understood that the embodiments of FIGs. 6 and 7 are merely examples, and the system 500 may be connected between a heat exchange system and one, two, three, or more separate cooling systems 80 which may be, for example one, two, three or more separate chillers 85. In such a case, the system 500 may include additional flexible hoses to connect to the multiple lines extending between the multiple cooling systems/chillers and the heat exchange system 90.

In an example embodiment in which two or more cooling systems/chillers are attached to the system 500 in parallel, one of the cooling systems/chillers may be used in its capacity as a system pump, while the other of the cooling systems/chillers may be provided as backup, may be redundant, or may be used for additional cooling capacity to aid in maintaining the temporary cooling function. When chillers are used to provide pumping, they may be arranged or hydraulically connected to the ramp in parallel to provide additional capacity. Likewise, each chiller may include its own pump, either integrated within the unit itself or connected as a dedicated external pump. Combinations of chillers with and without integrated pumps may be connected in parallel. According to another example embodiment, one or more external pumps may be connected together, and the thus-connected pumps may be connected in series with a number of chillers, where the chillers themselves are connected to the ramp in parallel. In such a configuration, a good hydronic balancing of chillers is important, as would be understood by one of skill in the art.

When the auxiliary cooling ramp 590 is to be filled, the valve 571 may be used, and both valves 571 and 574 may be used to drain the ramp 590.

The auxiliary cooling ramp may include multiple of each of the isolation valves 121 and 123 such that when multiple chillers attached, each of the multiple chillers may be independently attached to an isolation valve 121 and an isolation valve 123.

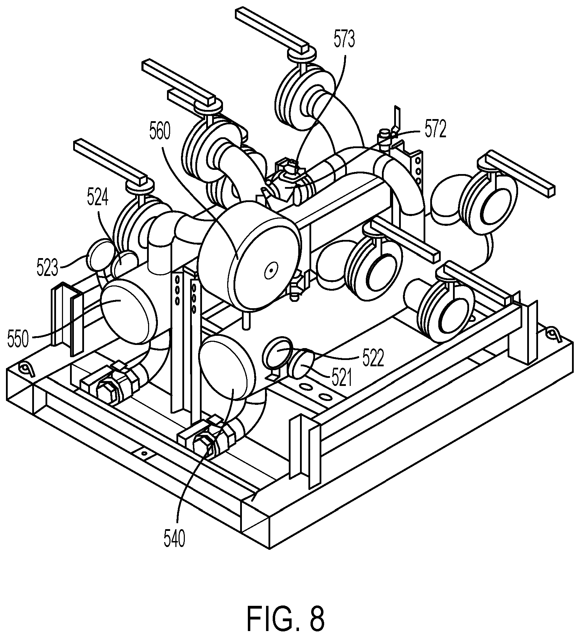

FIG. 8 is a perspective view of an auxiliary cooling ramp according to an example embodiment, showing an example arrangement of the CHW supply manifold 540; the CHW return manifold 550; the expansion tank 560; pressure gauges 521, 523; temperature gauges 522, 524; the pressure-independent balancing valve 572; and the deaeration valve 573.

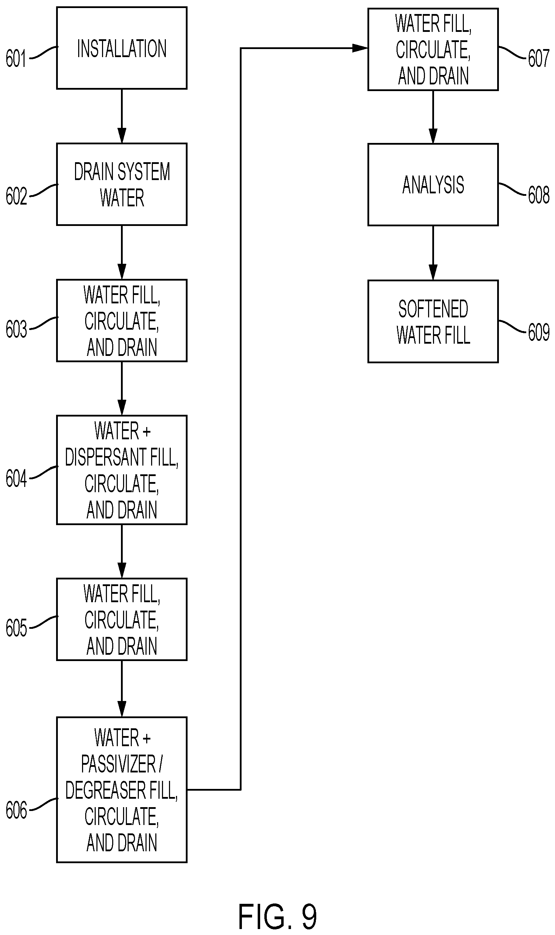

FIG. 9 is a flow chart of a method of operating an auxiliary cooling ramp according to an example embodiment. The system 500 is installed by locating the ramp 590 in a convenient operating space and operatively connecting the ramp 590 between a heat exchange system and the one or more cooling systems via the hoses (601). Current system water, including any contaminants therein, is drained from the system via one or both of the drain/filling valves (602). The system is then filled with hydrant water (i.e. water provided from outside the system) which is left to circulate through the system, including the heat exchange system, the ramp, and the one or more cooling systems, and is then drained from the system (603).

The hydrant water may be left to circulate for at least one hour, for example, prior to being drained. The system is then filled with a mixture of fresh water and a dispersant (604). The fresh water may be hydrant water that has been softened and/or otherwise adjusted. The dispersant may be, for example, Nalco 3D TRASAR^{™} 3DT120, and may be included in a concentration of 100 ppm. However, this dispersant and concentration are merely examples, and another dispersant and/or another concentration may be used, as determined by an operator skilled in the art. The water/dispersant mixture is left to circulate through the system for three hours, for example, and is then drained (604). The system is then filled once again with hydrant water which is left to circulate through the system for, for example one hour, and is then drained from the system (605). The system is then filled with a mixture of fresh water and a passivizer/degreaser (606). The passivizer/degreaser may be, for example, Nalco NALPREP^{™} IV, and may be included in a concentration of 5000 ppm. However, this passivizer/degreaser and concentration are merely examples, and another passivizer/degreaser and/or another concentration may be used, as determined by an operator skilled in the art. The mixture of fresh water and passivizer/degreaser may be left to circulate through the system for 24-48 hours, for example, and is then drained from the system (606). After draining the mixture of fresh water and passivizer/degreaser, the system is again filled with hydrant water which is left to circulate through the system, for example, for one hour, and is then drained (607). Finally, a water analysis is performed (608), and the system is filled with softened water in a mixture with propylene glycol and a corrosion inhibitor (609). The softened water may have a hardness between about 4.5-8.5 degrees of General Hardness (°dH), and may be in a 30% propylene glycol mixture. The corrosion inhibitor may be Nalco TRASAR^{™} TRAC100 and may be included in a concentration of 2800 ppm. However, the water hardness, the propylene glycol mixture, the corrosion inhibitor, and the concentration are merely examples, and another hardness, propylene glycol mixture, corrosion inhibitor, and/or concentration may be used, as determined by an operator skilled in the art.

The parameters by which an operator could determine the time for which the hydrant water and fresh water with additives are left to circulate, the parameters by which an operator could determine the specific additives and their concentrations to be added during the various stages, and parameters of the final water analysis and parameters by which an operator could determine the specific types and quantities of the additives to be included with the final softened water could be determined by a water treatment specialist based on system needs. For example, a specialist could initially take water samples of contaminated water and compare values of this initial contaminated water to those which the final clean/new water (with corrosion inhibitor and/or other additives) should have when introduced into the system after the system has been cleaned. According to the comparison of values, a specialist could determine a time for circulation, specific additives and their concentrations, sequences of introducing specific additives and times for circulation of each step with specific additives/chemicals. During the circulation, the specialist could additionally take samples of water to check parameters. With these read values, a specialist may have insight into what is happening inside the system, whether the method is effective, whether it has been circulated enough or if it needs to be circulated more.

According to one or more example embodiments, the method described above with respect to FIG. 9 may be modified in any of a variety of different ways in order to customize one or more operations for use in conjunction with a particular cooling system or heat exchange system or based on parameters of the cooling system, heat exchange system or state of the system water prior to operation of the auxiliary ramp. Such modifications can be determined by an engineer of skill in the art. Likewise, one or more of the operations of the method described above may be modified in order to optimize operations. For example, the introduction of water and water mixtures into the system in operations 603, 604, 605, 606, 607, and 609 may be a controlled injection using, for example an automatic pressurization system, in order to aid in removing the possibility of human error. Automatic deaeration may be performed in conjunction with one or more of operations 603, 604, 605, 606, 607, and 609, for example in a system including iron and/or copper materials in order to aid in limiting corrosion potentially leading to a shorter life cycle of the equipment. Use of the corrosion inhibitor in operation 609, for example may aid in preventing oxidation of iron and/or copper due to air trapped in the system. The passivation and degreasing chemicals may additionally be mixed with softened water to be used for a full heat load test or a factory acceptance test, for example, in place of using only hydrant water.

A method according to another example embodiment may additionally include an operation of testing water quality in the system prior to operation 601 or 602, and/or testing water quality again after operation 609.

The buffer tank has access points to ensure that complete cleaning is possible. The buffer tank may be considered to be part of the cooling system and may be connected between the CHW supply manifold 540 and the cooling system 80.

According to one installation and operation of an auxiliary ramp according to an example embodiment, testing of water in the system prior to installation of the auxiliary ramp showed that the system had been filled with softened water with less than 5 ppm CaCO₃ or approximately 0°dH and polypropylene glycol in a thirty percent ratio without a corrosion inhibitor. After the system had been in operation for a certain amount of time, water testing showed a substantial quantity of iron, both dissolved and undissolved, copper, and oxygen in the water and high levels of hardness and conductivity. The measured high concentrations of iron and oxygen indicated signs of corrosion, and the concentration of hardness indicated that the system had been refilled with hydrant water and that elevated pH values would lead to scaling in the pipes. The high concentration of oxygen indicated that the system could not be deaerated manually, and that there would always be oxygen in the system which would lead to oxidation and corrosion of the metals in the system.

During this example installation and operation, an analysis of the water prior to installation of the ramp showed the following values:

| | | |
|---|---|---|
| pH | 9,2 | 9,1 |
| Conductivity - µS/cm | 221 | 221 |
| Total hardness -ppm (mg/l)CaCO₃ | 200 | 200 |
| Calcium hardness -ppm (mg/l)CaCO₃ | 100 | 100 |
| M- Alkalinity - ppm (mg/l) CaCO₃ | 800 | 600 |
| P- Alkalinity - ppm (mg/l) CaCO₃ | 400 | 20 |
| Nitrite - ppm (mg/l), NO²⁻ | 0 | 230 |
| Sulfite - ppm (mg/l), SO₃²⁻ | 90 | 60 |
| Sulfate - ppm (mg/l), SO₄⁻ | 500 | 50 |
| Silica - ppm (mg/l), SiO₂ | 225 | 429 |
| Iron (II) Ferrous - ppm (mg/l), Fe²⁺ | 24,8 | 24,0 |
| Iron total - ppm (mg/l), Fe | 59,75 | 70,25 |
| Copper - ppm (mg/l), Cu | 300 | 260 |
| COD - ppm (mg/l), O₂ | < 200 000 | - |

Also during this example installation and operation, the following table was used as a reference for final water analysis values:

| **Physical and chemical parameters** | |
|---|---|
| **Parameter** | **Guideline** |
| Total alkalinity (mg/l CaCO₃) | As recommended by the cleaning specialist in their sampling and analysis plan |
| Chloride (mg/l Cl) | |
| Sulfate (mg/l SO₄₎ | |
| Conductivity (µS/cm) | |
| Total dissolved solids (gravimetric) (mg/l) | |
| Suspended solids* (mg/l) | Less than 30 mg/l at main pump during circulation Less than 45 mg/l at system extremities and terminal units |
| pH | As recommended by the cleaning specialist in their sampling and analysis plan depending on system materials and water treatment regime |
| Dissolved iron (mg/l) | Less than 3mg/l or as recommended by the cleaning specialist in their sampling and analysis plan |
| Total iron (mg/l) | Less than 6 mg/l or as recommended by the cleaning specialist in their sampling and analysis plan |
| Dissolved copper (mg/l) | Less than 1 mg/l or as recommended by the cleaning specialist in their sampling and analysis plan |
| Total copper (mg/l) | Less than 1 mg/l or as recommended by the cleaning specialist in their sampling and analysis plan |
| Total aluminium** (mg/l) | Less than 1 mg/l |
| Chemical inhibitor levels | As recommended by the cleaning specialist in their sampling and analysis plan |

According to one or more example embodiments described herein, an auxiliary cooling ramp system may be provided which is portable and adaptable and may be attached to existing lines; may require only a small installation space; and may be operated without interrupting cooling operations and thus may enable maintenance of temperatures within an acceptable range thus keeping in compliance with service level agreements with, for example, data center clients.

It may be understood that the example embodiments described herein may be considered in a descriptive sense only and not for purposes of limitation. Descriptions of features or aspects within each example embodiment may be considered as available for other similar features or aspects in other example embodiments.

While example embodiments have been described with reference to the figures, it will be understood by those of ordinary skill in the art that various changes in form and details may be made therein without departing from the scope as defined by the following claims.

## Claims

1. An auxiliary ramp system comprising:
an auxiliary ramp unit comprising:
a supply manifold,
a return manifold,
a pressure-independent balancing valve operatively connected between the supply manifold and the return manifold,
a safety valve operatively connected to the return manifold, and
a drain/filling valve operatively connected to one of the supply manifold and the return manifold; and
a plurality of flexible hoses comprising:
a supply input hose configured to attach to an input of the supply manifold,
a supply output hose configured to attach to an output of the supply manifold,
a return input hose configured to attach to an input of the return manifold, and
a return output hose configured to attach to an output of the return manifold.

2. The system according to claim 1, wherein the return manifold comprises a plurality of inputs and a plurality of outputs and wherein the plurality of flexible hoses comprises a plurality of return input hoses each configured to attach to one of the plurality of inputs of the return manifold and a plurality of return output hoses each configured to attach to one of the plurality of outputs of the return manifold.

3. The system according to claim 1 or 2, wherein the auxiliary ramp unit further comprises a deaeration valve operatively connected between the supply manifold and the return manifold.

4. The system according to any preceding claim, wherein the auxiliary ramp unit further comprises an isolation valve operatively connected between the safety valve and the return manifold.

5. The system according to any preceding claim, wherein the drain/filling valve comprises a first drain filling valve operatively connected to the supply manifold and a second drain/filling valve operatively connected to the return manifold.

6. The system according to any preceding claim, further comprising a pump configured to pump water through the supply manifold.

7. The system according to any preceding claim, wherein the auxiliary ramp unit further comprises a first pressure gauge and a first temperature gauge operatively attached to the supply manifold and a second pressure gauge and a second temperature gauge operatively attached to the return manifold.

8. The system according to any preceding claim, wherein the auxiliary ramp unit further comprises an expansion tank operatively connected to the via an isolation valve return manifold.

9. A cooling system maintenance method comprising:
draining water from a water circuit of a combined cooling system comprising a cooling unit and a heat exchange system;
filling the water circuit with first water via an auxiliary ramp unit, allowing the first water to circulate in the water circuit, and draining the first water from the water circuit,
wherein the auxiliary ramp unit is operatively connected on lines of the water circuit between the cooling unit and the heat exchange system;
filling the water circuit with a first mixture comprising water and a dispersant via the auxiliary ramp unit, allowing the first mixture to circulate in the water circuit, and draining the first mixture from the water circuit;
filling the water circuit with second water via the auxiliary ramp unit, allowing the second water to circulate in the water circuit, and draining the second water from the water circuit;
filling the water circuit with a second mixture comprising water and a passivizer/degreaser, allowing the second mixture to circulate in the water circuit, and draining the second mixture;
filling the water circuit with third water via the auxiliary ramp unit, allowing the third water to circulate in the water circuit, and draining the second water from the water circuit; and
filling the water circuit with a softened water mixture via the auxiliary ramp unit.

10. The method of claim 9, further comprising:
installing the auxiliary ramp unit between the cooling unit and the heat exchange system, the installing comprising:
attaching a flexible supply input hose between an input of a supply manifold of the auxiliary ramp unit and an output of the cooling unit;
attaching a flexible supply output hose between an output of the supply manifold and an input of the heat exchange system;
attaching a flexible return input hose between an input of a return manifold of the auxiliary cooling ramp unit and an output of the heat exchange system, and
attaching a flexible a return output hose between an output of the return manifold and an input of the cooling unit.

11. The method according to claim 9 or 10, further comprising:
deaerating the water circuit via a valve of the auxiliary cooling ramp unit operatively connected between a supply manifold of the auxiliary cooling ramp unit and a return manifold of the auxiliary cooling ramp unit.

12. The method according to any of claims 9 to **11,** wherein the allowing the first water to circulate, allowing the second water to circulate, and allowing the first water to circulate each comprise allowing circulation of the water to continue for an hour prior to draining and/or wherein the first mixture comprises water and the dispersant in a concentration of about 100 ppm and/or wherein the second mixture comprises water and the passivizer/degreaser in a concentration of about 5000 ppm.

13. The method according to any of claims 9 to 12, wherein the softened water mixture comprises softened water in a 30% propylene glycol mixture and a corrosion inhibitor.

14. The method according to claim 13, wherein the softened water mixture includes the corrosion inhibitor in a concentration of about 2800 ppm and/or wherein the softened water has a hardness between about 4.5-8.5 °dH.

15. The method according to any of claims 9 to 14, wherein allowing the first mixture to circulate comprises allowing the first mixture to circulate for about three hours prior to draining the first mixture and/or wherein the operation of allowing the second mixture to circulate comprises allowing the second mixture to circulate for between about 24-48 hours prior to draining the second mixture and/or wherein the operations of filling the water circuit comprise filling the water circuit via a controlled injection using an automatic pressurization system.
